# EUROPEAN PATENT SPECIFICATION

(11) **EP 0 504 886 B1**
(45) Date of publication and mention of the grant of the patent: **04.03.1998**
(21) Application number: 92104795.7
(22) Date of filing: 19.03.1992
(51) Int. Cl.: C30B 25/10, C23C 16/48

(54) **A vapour depositing method and use of an apparatus therefor**
Verfahren und Gebrauch einer Vorrichtung zur Dampfphasen-Abscheidung
Procédé et utilisation d'un appareillage de dépôt en couche de vapeur

(30) Priority: 20.03.1991 JP 56931/91
(43) Date of publication of application: 23.09.1992
(73) Proprietor: KOKUSAI ELECTRIC CO., LTD., Tokyo-to (JP)
(72) Inventor: Murota, Junichi, Sendai-shi, Miyagi-ken (JP); Ono, Shoichi, Sendai-shi, Miyagi-ken (JP); Sakuraba, Masao, Sapporo-shi, Hokkaido (JP); Mikoshiba, Nobuo, Sendai-shi, Miyagi-ken (JP); Kurokawa, Harushige, Higashimurayama-shi, Toyko (JP); Ikeda, Fumihide, Toyama-shi, Toyama-ken (JP)
(74) Representative: Walter, Helmut, Dipl.-Ing.

(56) References cited:
- GB-A- 2 162 369
- CHEMTRONICS. vol. 4, no. 3, September 1989, GUILDFORD GB pages 117 - 122; AOYAGI ET AL.: 'Mechanism and application of laser atomic layer epitaxy of GaAs'
- JAPANESE JOURNAL OF APPLIED PHYSICS. vol. 28, no. 8, August 1989, TOKYO JP KAWAKYU ET AL.: 'GaAs atomic layer epitaxy using the KrF excimer laser' Pages L1439-L1441
- JOURNAL OF APPLIED PHYSICS. vol. 64, no. 6, 15 September 1988, NEW YORK US pages 3254 - 3262; KAWASAKI ET.AL: 'Study on the early stage of photochemical vapour deposition of amorphous silicon from disalane on a SiO2 substrate.'

## Description

### BACKGROUND OF THE INVENTION

### 1. Field of the Invention

The present invention relates to a vapor deposition method comprising placing a sample in a reaction chamber, evacuating the reaction chamber, introducing at least one gaseous material and applying at least one pulse of a pulse waveform light to the sample.

### 2. Description of the Prior Art

There is a conventional vapor depositing method in which gaseous material flows from a gas source into a reaction clamber, while a sample in the reaction chamber is heated by a high frequency heater, thereby a CVD film is deposited on the sample. In such a method, since adsorption and reaction take place continuously on the surface of the sample, it is very difficult to produce a film in the form of an atomic layer or in the form of plural atomic layers.

Heretofore, in vapor deposition of a film in the form of an atomic layer or in the form of plural atomic layers, a compound semiconductor was used as the objective material. For example producing of a GaAs layer in the form of an atomic layer or the form of plural atomic layers is carried out by utilizing the characteristic of As that As is not deposited on As.

Further there is a method in which gaseous material is adsorbed by a sample, and thereafter gaseous material in a vapor phase is exhausted, and then the adsorbed substance is decomposed and reacted by the application of light to the sample, and series of the above-mentioned processes are repeated.

However, in the former method, deposition of an elemental semiconduclor such as Si and Ge is impossible. On the other hand, in the latter method, producing of a film in the form of an atomic layer or in the form of plural atomic layers is possible when using organic or halogen gas as the gaseous material. However, in the latter method, when hydride is used as a gaseous material, there is the problem that when exhaust gas material is exhausted in a vapor phase, so that the adsorbed substance is removed from the surface of the sample.

In Chemtronics 4(3), 03.09.1989, Guildford, GB, pages 117-122, Aoyagi et al.: "Mechanism and Application of Laser Atomic Layer Epitaxy of GaAs" is described a method for producing GaAs layers with laser irradiation. A TEG-gas and the laser are applied simultaneously to a sample in order to get one atomic layer. The TEG adsorbed on the As atomic surface is quickly decomposed under the laser irradiation and once the As surface is covered by Ga or a Ga compound, the TEG adsorbed on the Ga film does not decompose any more.

According to another method for producing GaAs layers (Jap.J.Appl. Phys. 28(8) Part 2, August 1989, Tokyo, JP, pp.L1439-L1441; Kawakyu et al.: "GaAs Atomic Layer Epitaxy Using the KrF Excimer Laser")the gases TMG and AsH₃ are alternately supplied to the GaAs growing surface while the substrate is irradiated repeatedly by KrF excimer laser pulses. Also here the laser irradiates the substrate at the same time the gas is supplied into the reaction chamber.

According to a further method for producing GaAs layers (GB A-2 162 369) a mercury lamp is continuously directed toward and onto the substrate, whereby the mercury lamp may also be energized discontinuously.

### BRIEF SUMMARY OF THE INVENTION

It is one object of the present invention to provide a vapor depositing method for producing a film in the form of an atomic layer or in the form of plural atomic layers, in which in the surface of a layer of geseous material the adsorbed substance occur separately and it is possible to instantaneously decompose and react the adsorved substance with light after the gaseous material has been adsorbed on the surface of the sample.

This object is achieved by a vapor deposition method comprising placing a sample in a reaction chamber, evacuating the reaction chamber, introducing at least one gaseous material and applying at least one pulse of a pulse waveform light to the sample after introducing the at least one gaseous material, characterized in introducing the at least one gaseous material under such high partial pressure that the gaseous material can be entirely adsorbed on the substantially whole surface of the sample, after the gaseous material has been entirely adsorbed on the substantially whole surface only one pulse of a pulse waveform light from a flash lamp is applied to the sample whereby one atomic layer is produced.

This method can be accomplished by use of a vapor deposition apparatus comprising a reaction chamber having a window, a flash lamp for applying a pulse waveform light to a sample through the window, and comprising a stand for placing the sample, further comprising a gas source for supplying at least one gaseous material to said reaction chamber, and comprising means for supplying the gaseous material under such high partial pressure that the gaseous material can be entirely adsorbed on the substantially whole surface of the sample, and further comprising a control unit for controlling the flash lamp in order to emit only one pulse of a pulse waveform light to the surface of the sample after waiting a preselected lapse of time after the gaseous material is supplied to allow the gaseous material to be entirely adsorbed on the substantially whole surface of the sample for forming one atomic layer on the surface of the sample after the application of the one light pulse.

According to the present invention, producing of a film in the form of an atomic layer or in the form of plural atomic layers by applying light to the sample in the rection chamber from a source of the light of pulse waveform while introducing gaseous material from a gas source into the reaction chamber and exposing the sample in the reaction chamber to the gaseous material : after adsorption of the gaseous material on the surface of the sample, the adsorbed substance can be instantaneously decomposed and reacted by light of the pulse waveform so that a film in the form of an atomic layer or in the form of plural atomic layers is produced on the sample.

### BRIEF DESCRIPTION OF THE DRAWINGS

In the drawings,

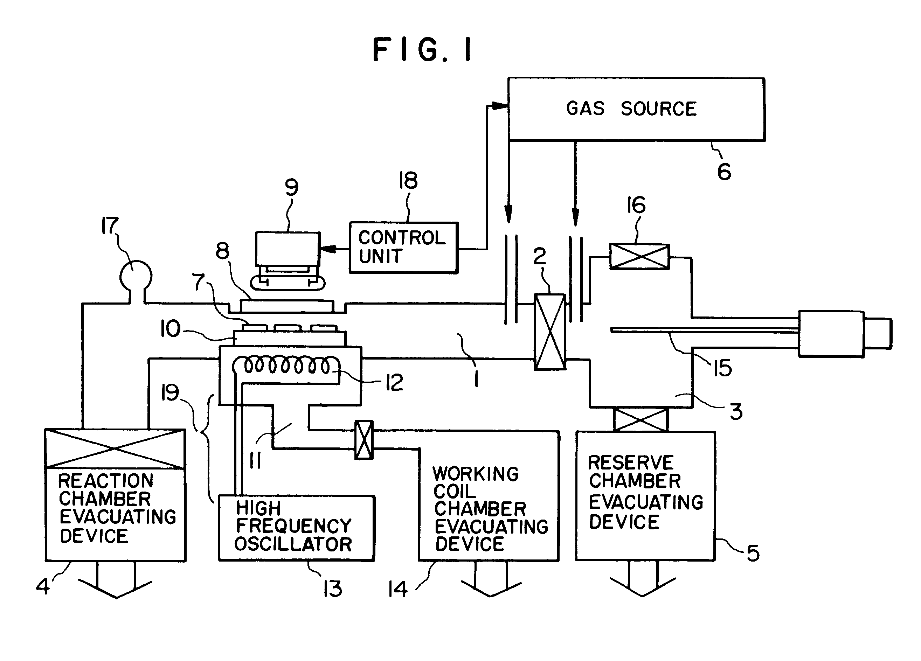

Fig. 1 is a schematic representation of an example of an apparatus used in the present invention,

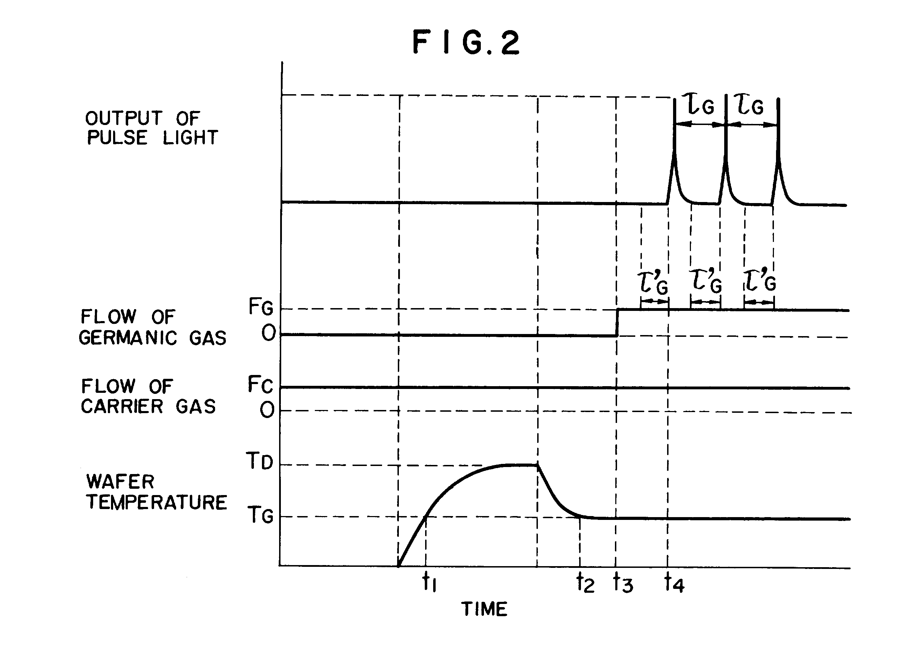

Fig. 2 graphically shows an example procedure for depositing germanium on a wafer, when the light from a xenon lamp is repeatedly applied to the surface of the wafer,

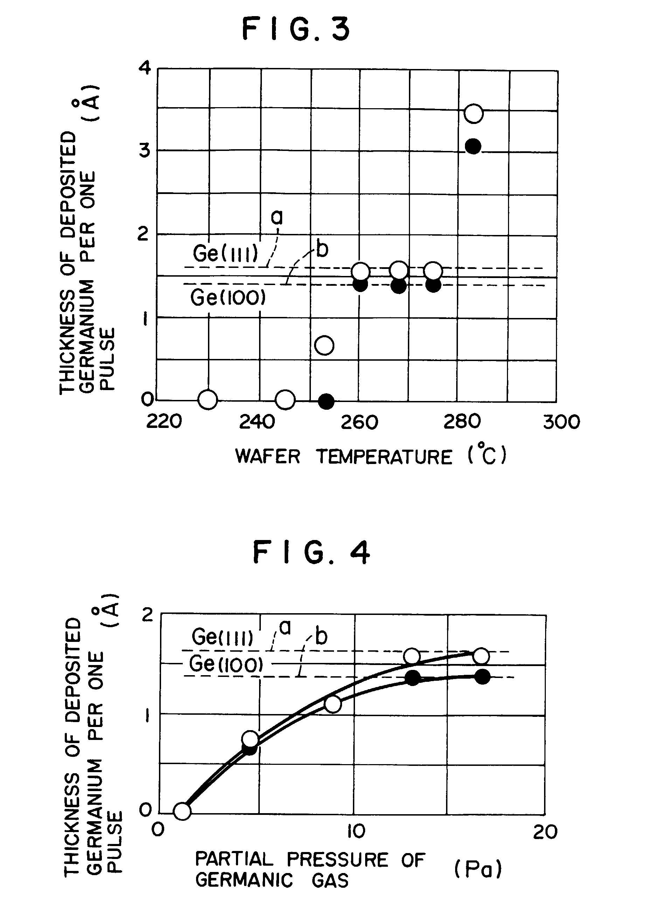

Fig. 3 is a graphical representation of variation of thickness (Å) of deposited germanium on a monocrystal silicon wafer per pulse relative to wafer temperature ( °C), wherein the dependence of the thickness of deposited germanium on the wafer per one pulse on the wafer temperature is represented, when light from a xenon flash lamp is repeatedly applied to the surface of the wafer
Fig. 4 is a graphical representation of variation of thickness (Å) of deposited germanium on a monocrystal silicon wafer per pulse relative to partial pressure (Pa) of germanic gas inside the reaction chamber, wherein the dependency of the thickness of deposited germanium on the wafer per pulse on the partial pressure (Pa) of germanic gas inside the reaction chamber is represented when light from a xenon flash lamp is repeatedly applied to the surface of the wafer,

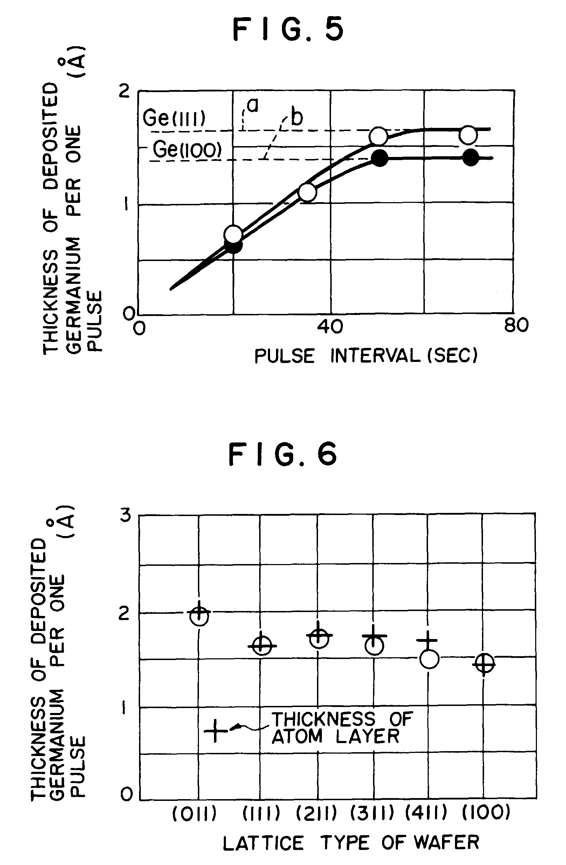

Fig. 5 is a graphical representation of variation of thickness (Å) of deposited germainium on a monocrystal silicon wafer per pulse relative to the pulse interval (sec.), wherein the dependency of the thickness of deposited germanium on the wafer per pulse on the pulse interval is represented, when light from a xenon flash lamp is repeatedly applied to the surface of the wafer,
Fig. 6 is a grahical representation of variation of thickness of deposited germanium on a monocrystal silicon wafer per pulse ( Å) with a lattice type wafer, wherein the dependency of the thickness of deposited germanium on the wafer per pulse on the lattice type wafer is represented, when light from a xenon flash lamp is repeatedly applied to the surface of monocrystal silicon wafer,

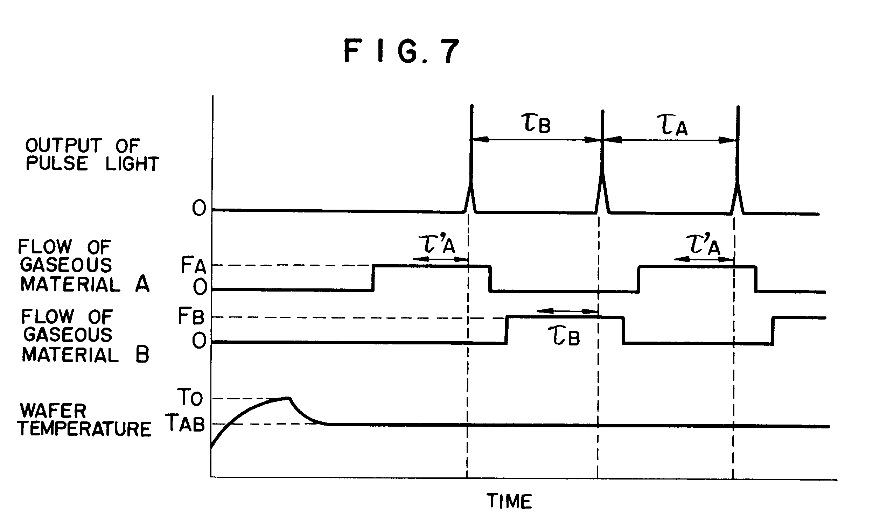

Fig. 7 graphically shows an example procedure for forming a multiatomic layered film including an alternately superimposed layer of substance B on a layer of substance B on a wafer comprising the alternate introduction of gaseous materials A and B into the reaction chamber and the application of light from a xenon flash lamp to the wafer once per introduction of respective gaseous materials A and B into the reaction chamber by which a multiatomic layered film including alternately superimposed layer of substance B on layer of substance B is formed,

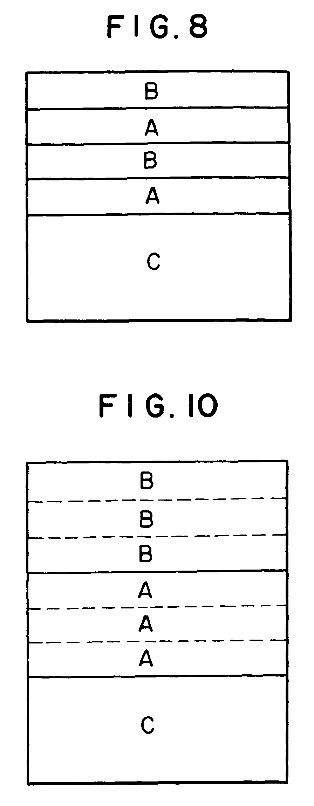

Fig. 8 is a sectional view of the multiatomiclayered film formed on a wafer according to the procedure graphically shown in Fig. 7,

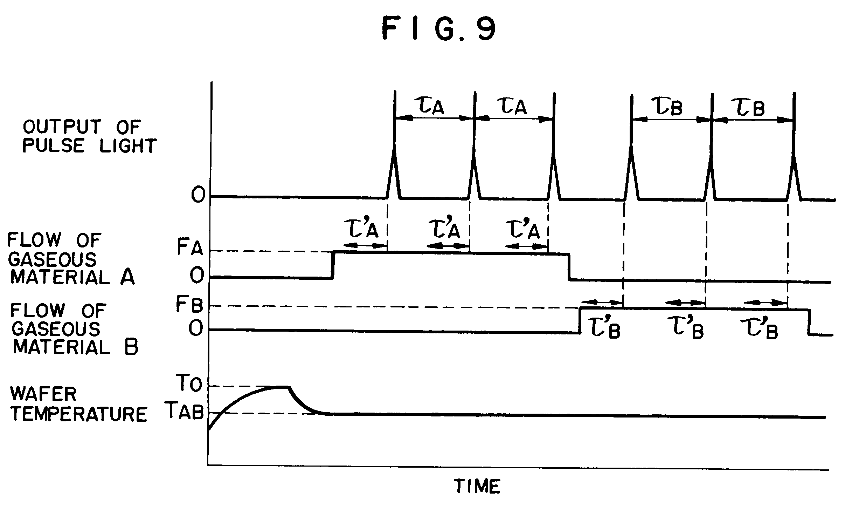

Fig. 9 graphically shows an example procedure for forming a film including three alternately superimposed layers of substance B on three layers of substance B on a wafer comprising alternate introduction of gaseous materials A and B into the reaction chamber and the application of the light of xenon flash lamp to the wafer three times per introduction term of respective gaseous materials A and B into the reaction chamber by which a multiatomic layered film including alternately superimposed layers of substance B on layers of substance B is formed,

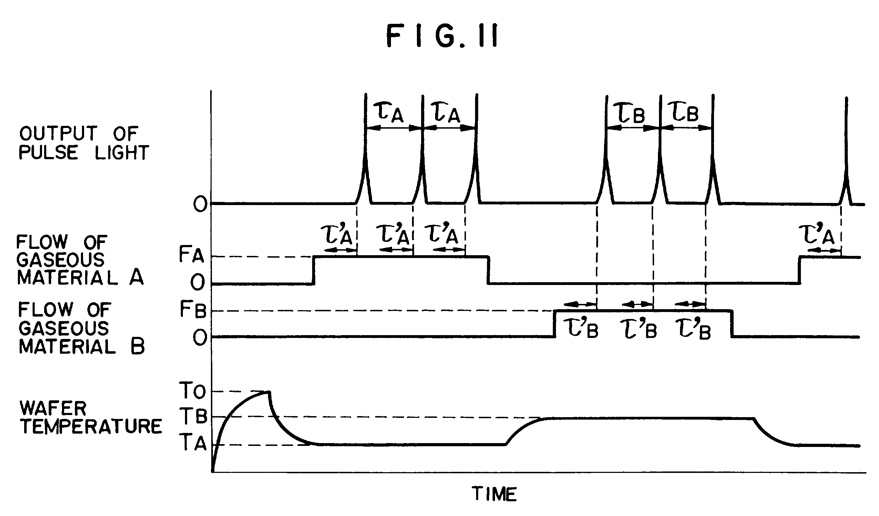

Fig. 10 is a sectional view of the multiatomic layered film formed on a wafer according the procedure shown in Fig. 9,
Fig. 11 graphically shows an example procedure for forming a film including three alternately superimposed layers of substance B on three layers of substance B on a wafer comprising alternate introduction of gaseous materials A and B into the reaction chamber, the application of light from a xenon flash lamp to the wafer three times per introduction term of respective gaseous materials A and B into the reaction chamber, and changing wafer temperature in association with the introduction terms of respective gaseous material A and B by which a multiatomic layered film including alternately superimposed layers of substance B on layers of substance B is formed,

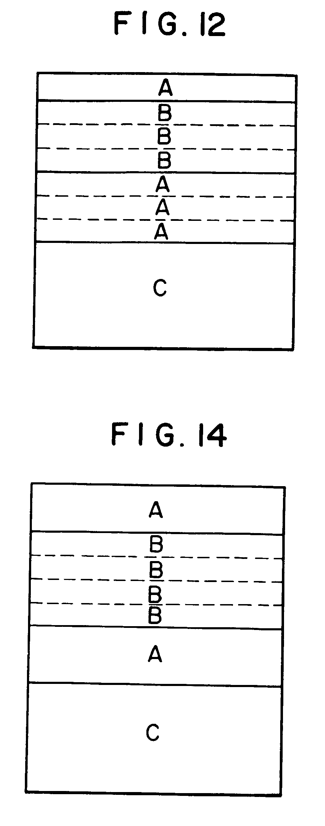

Fig. 12 is a sectional view of the multiatomiclayered film forned on a wafer according the procedure shown in Fig. 11,

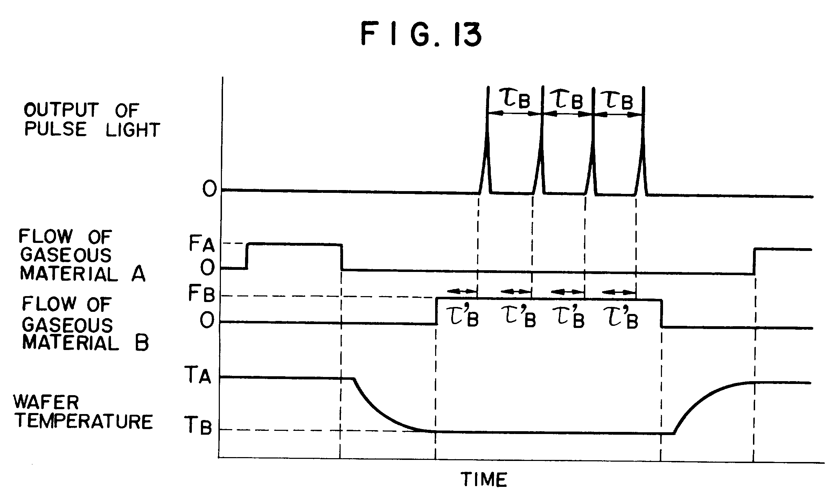

Fig. 13 graphically shows an example procedure for forming a film including three alternately superimposed layers of substance B on three layers of substance B on a wafer comprising forming a layer of substance A according to conventional vapor deposition without applying light from a pulse waveform to the wafer and forming plural layers of substance B on the layer of substance A while applying light from a pulse waveform to the wafer according to the present invention, and
Fig. 14 is a sectional view of the multiatomic layered film formed on a wafer according the procedure shown in Fig. 13.

### DETAILED DESCRIPTION

Referring to Fig. 1, an apparatus used in the present invention comprises reaction chamber 1, reserve chamber 3 communicating with reaction chamber 1 through door 2 of reaction chamber 1, reaction
chamber evacuating device 4, reserve chamber evacuating device 5, gas source 6 for supplying gaseous material to reaction chamber 1 and to reserve chamber 3, and a flash lamp 9 for applying light from flash lamp 9 to the surface of sample 7 in reaction chamber 1 through transparent window 8.

The apparatus according to the present invention further comprises sample stand 10, working coil chamber 11 for supplementary heating of sample 7, said working coil chamber 11 being provided underneath sample stand 10. High frequency oscillator 13 supplys high frequency to working coil 12 provided in working coil chamber 11. Sample conveyor 15 conveys sample 7 to reaction chamber 1, said sample conveyor 15 being provided in reserve chamber 3. Sample 7 is carried through door 16 into reserve chamber 3, and control unit 18 controls the application of light from the flash lamp to sample 7 in association with the introduction of gaseous material into reaction chamber 1. Reaction chamber 1 is provided with a pressure meter 17.

In the following a method for producing a film in the form of an atomic layer or in the form of plural atomic layers by using the above-mentioned apparatus to carry out the method of the present invention is explained. The formation of a film is carried out by the following procedure: (1) reaction chamber 1 and working coil chamber 11 are evacuated by reaction chamber evacuating device 4 and working coil evacuating device 14, respectively, (2) thereafter carrier gas such as hydrogen is supplied to reaction chamber 1 which has been evacuated from gas source 6, (3) reserve chamber 3 is filled with inert gas such as nitrogen to atmospheric pressure, then the door 16 of reserve chamber 3 is opened, and after the sample is placed on sample conveyer 15 in reserve chamber 3, door 16 is shut, (4) reserve chamber 3 is evacuated by reserve chamber evacuating device 5 to a reduced pressure, while the same gas as the gas supplied to reaction chamber 1 is supplied to reserve chamber 3, (5) the door 2 of reaction chamber 1 is opened, and sample 7 is carried from reserve chamber 3 into reaction chamber 1 by sample conveyor 15, placed on sample stand 10, sample conveyor 15 is returned to reserve chamber 3, and door 2 is shut, (6) high frequency is applied to working coil 12 from high frequency oscillator 13, thereby sample stand 10 is heated, heating sample 7, wherein heating of sample 7 is carried out with a view to promoting decomposition and reaction of gaseous material under application of light from a flash lamp, or with a view to separating an unnecessary adsorbed substance on the surface of sample 7, and with a view to forming a film by a conventional chemical vapor depositing method, (7) thereafter gaseous material is supplied frome gas source 6 to reaction chamber 1, and (8) after the time required for adsorbing gaseous materials on the surface of sample 7, light from a flash lamp is applied from flash lamp 9 to the surface of sample 7 through transparent window 8.

In the method according to the present invention, the application of light from flash lamp 9 to the sample is controlled in association with the flow of gaseous material into reaction chamber 1 by control unit 18, and plural kinds of gaseous materials can flow into reaction chamber 1 at the same time or alternately. Further, after applying light from flash lamp 9 to simple 7 while one gaseous material flows into reaction chamber 1, another gaseous material flows into reaction chamber 1, and then by heating sample 7, different substances can be deposited on sample 7.

Fig. 2 is a graphical representation of a time schedule for the application of pulse waveform light to a monocrystal silicon wafer and the introduction of germanic gas into the reaction chamber, together with the output of the pulse waveform light, flow of germanic gas, flow of carrier gas, and change of wafer temperature with time, wherein there is represented an example of a procedure for depositing germanium on a wafer, when the light from a xenon lamp is repeatedly applied to tie surface of the wafer.

Referring to Fig.2, one example procedure when forming germanium for example on a monocrystal silicon wafer is explained. Hydrogen gas 200cm³/min flows into reaction chamber 1. When the pressure inside reaction chamber 1 reaches 270 Pa, the monocrystal silicon wafer(sample 7) is placed on sample stand 10, heated to a wafer temperature TG between 230°C and 290°C at time t₁, further heated to temperature TD of more than 400°C so that unnecessary material adsorbed on the surface of wafer to removed, and thereafter cooled to a wafer temperature TG till t₂.

Then, germanic gas (GeH₄) is introduced into reaction chamber 1 at time t₃ so that the partial pressure reaches 1-20 Pa, and after the lapse of time τ 'G required for the germanic gas to be adsorbed on the sample 7 in which τ G designates the repeated pulse interval of the light of pulse waveform, light from a xenon flash lamp with 20J/cm² with pulse width of 1ms is repeatedly applied to the surface of monocrystal silicon wafer at time t₄.

According to the above-mentioned method, the thickness of germanium film deposited on sample 7 per pulse is investigated. When the total pressure of GeH₄-H₂ gas mixture is 280 Pa, the partial pressure of germanic gas (GeH₄) is 13 Pa, and the pulse interval τG is 20 seconds, the deposition of one atomic layer of germanium per pulse is recognized on Si of lattice type (1 0 0) and Si of lattice type (1 1 1), respectively, at a temperature between 260 °C and 275°C without depending upon temperature as shown in Fig. 3, in which ○ designates the thickness of germanium deposited on Si of the lattice type (1 1 1) per pulse, ● designates the thickness of germanium deposited on Si of the lattice type (1 0 0), and a broken line "a" designates the thickness of one atomic layer of Ge of lattice type (1 1 1) with a wafer temprature, and broken line "b" designates the change of the thickness of one atomic layer of Ge of the lattice type (1 0 0). The same applies to Figs. 4-5.

When the total pressure of GeH₄-H₂ gas mixture is 280 Pa, and the wafer temperature is 268°C, it is recognized that at a partial germanic gas pressure of more than 13 Pa, germanium of one atomic layer per pulse is deposited as shown in Fig. 4.

When the total pressure of GeH₄-H₂ gas mixture is 280 Pa, and the wafer temperature is 268°C, it is recognized also that at a partial germanic gas pressure of 4.5 Pa, germanium of one atomic layer per pulse is deposited when pulse interval is long as shown in Fig. 5.

However at a temperature between 230°C and 290°C, when light from flash lamp 9 is applied to sample 7, deposition of germanium is recognized. When the lattice type of wafer is changed, deposition of one atomic layer per pulse of germanium corresponding to the respective lattice type is recognized.

As above-mentioned, it is apparent that the application of pulse waveform light to sample 7 while exposing sample 7 to gaseous material makes it possible to form a of one atomic layer of germanium per pulse. Further, it is well known that formation of one atomic layer of mixed crystal is possible by a flow of material gas mixture including material gases of more than two kinds at the same time into reaction chamber 1.

Fig. 7 is a graphical representation of a time schedule for the application of pulse waveform light to a monocrystal silicon wafer, the introduction of gaseous material A into the reaction chamber, and the introduction of gaseous material B into the reaction chamber, together with an output of pulse waveform light, flow of gaseous material A, flow of gaseous material B, and change of the wafer temperature with time. The graph illustrates an example procedure for forming a multiatomic layered film including alternately superimposing a layer of substance A on a layer of substance B on the wafer comprising the alternate introduction of gaseous materials A and B into the reaction chamber and the application of light from a xenon flash lamp to the wafer once per introduction of respective gaseous materials A and B into the reaction chamber by which a multiatomic layered film including alternately superimposed layer of substance B on layer of substance A is formed.

According to the procedure shown in Fig. 7, the formation of a multilayered film in which one atomic layer of one substance A is arranged alternately with one atomic layer of another substance B on wafer C as shown in Fig. 8 is possible by controlling the application of light from flash tamp 9 to the sample 7 in association with the introduction of gaseous material into the reaction chamber 1, and by interchanging alternately one gaseous material A with another gaseous material B as shown in Fig. 7, in which designations τA and τB designate the pulse intervals when substance A and B are deposited on sample 7, respectively, and τ' A and τ' B designate the times required for material gases of substances A and B to be adsorbed into the surface of sample 7 and C designates the wafer.

Fig. 9 is a graphical representation of a a time schedule for the application of pulse waveform light to a monocrystal silicon wafer, the introduction of gaseous material A into the reaction chamber, and the introduction of gaseous material B into the reaction chamber, together with output of pulse waveform light, flow of gaseous material A, flow of gaseous material B, and change of the wafer temperature with time. The graph illustrates an example procedure for forming a film including three alternately superimposed layers of substance B on three layers of substance A on the wafer comprising the alternate introduction of gaseous materials A and B into the reaction chamber and the application of light from a xenon flash lamp to the wafer three times per introduction term of respective gaseous materials A and B into the reaction chamber by which a multiatomic layered film including alternately superimposed layers of substance B on layers of substance A is formed.

According to the procedure shown in Fig. 9, the formation of a multilayered film in which plural atomic layers of one substance A are arranged alternately with plural layers of another substance B at an interval of some number of layers is possible by controlling the application of light from flash lamp 3 to sample 7, and by interchanging one gaseous material A with another gaseous material B each time as shown in Fig. 9.

Fig. 11 is a graphical representation of a time schedule for the application of pulse waveform light to a monocrystal silicon wafer, the introduction of gaseous material A into the reaction chamber, and the introduction of gaseous material B into the reaction chamber, together with output of the light of pulse waveform, flow of gaseous material A, flow of gaseous material B, and change of the wafer temperature with time. The graph illustrates an example procedure for forming a film including three alternately superimposed layers of substance A on three layers of substance B on the wafer comprising the alternate introduction of gaseous materials and B into the reaction chamber, the application of light from a xenon flash lamp to the wafer three times per introduction term of respective gaseous materials A and B into the reaction chamber, and changing the wafer temperature in association with the introduction terms of respective gaseous material A and B by which a multiatomic layered film including alternately superimposed layers of substance B on layers of substance A is formed.

According to the procedure shown in Fig. 11, formation of a multilayered film in which plural atomic layers of one substance A are arranged alternately with plural atomic layers of another substance B at an interval of some number of layers is possible by controlling the wafer temperature in association with the introduction of gaseous material into reaction chamber 1 to be entirely adsorbed on the whole surface of sample 7.

In the present invention, it is preferable that the pulse interval is more than the time required for gaseous material to be entirely adsorbed into the whole surface of sample 7. Further, it is preferable that the application of pulse waveform light to sample 7 after the interchange of one gaseous material A with another gaseous material B is carried out after the lapse of the time required for another gaseous material B to be entirely adsorbed into the whole surface of the sample.

The above-mentioned examples are examples in which a multilayered structure comprised of different material layers is formed in the same reaction chamber. However, the multilayered structure can be formed by using some number of reaction chambers communicating with each other properly corresponding to substances to deposited.

Fig. 13 is a graphical representation of a time schedule for the application of pulse waveform light to monocrystal silicon wafer, the introduction of gaseous material A into the reaction chamber, and the introduction of gaseous material B into the reaction chamber, together with an output of pulse waveform light, flow of gaseous material A, flow of gaseous material B, and change of the wafer temperature with time. The graph illustratesd an example procedure for forming a film including four alternately superimposed layers of substance B on a layer of substance A on the wafer comprising forming a layer of substance A according to a conventional vapor deposition method without applying pulse waveform light to the wafer and forming plural layers of substance B on the layer of substance A by applying pulse waveform light to the wafer according to the present invention.

According to the procedure in Fig. 13, a multilayered structure can be formed as shown Fig. 14 in which A designates a film formed by conventional chemical vapor deposition and B designates a film formed by applying light from flash lamp 9 to sample 7 according to the present invention and C designates a wafer. This procedure combines the formation of film by a conventional vapor deposition with the above-mentioned method.

Further in the procedure shown in Fig. 13, it is apparent that it is possible to combine the device for forming a film without using a flash lamp with the reaction chamber using the flash lamp.

## Claims

1. A vapor deposition method comprising placing a sample in a reaction chamber, evacuating the reaction chamber, introducing at least one gaseous material and applying at least one pulse of a pulse waveform light to the sample after introducing the at least one gaseous material, characterized in introducing the at least one gaseous material under such high partial pressure that the gaseous material can be entirely adsorbed on the substantially whole surface of the sample, after the gaseous material has been entirely adsorbed on the substantially whole surface only one pulse of a pulse waveform light from a flash lamp is applied to the sample whereby one atomic layer is produced.

2. A vapor deposition method as claimed in claim 1 wherein a plurality of gaseous materials are introduced at the same time into the reacting chamber whereby a film comprised of mixed crystals is produced.

3. A vapor deposition method as claimed in claim 1 or 2 wherein the step of applying the only one light pulse after the gasoues material has been entirely adsorbed on the substantially whole surface is repeated a plurality of times for producing a plurality of atomic layers, wherein between each pulse the gasoeus material is allowed to be entirely adsorbed.

4. A vapor deposition method as claimed in claim 1 or 3 wherein selectively alternating the steps of introducing a first gaseous material and of irradiating with the one light pulse with the steps of introducing another gaseous material and of irradiating with the one light pulse for selectively producing different atomic layers on the sample.

5. A vapor deposition method as claimed in one of the claims 1 to 4 wherein before or after introducing the at least one gaseous material the sample is heated at a constant temperature and at least one another gaseous material is introduced whereby the another gaseous material reacts chemically to form layers.

6. A vapor deposition method as claimed in claim 1, wherein the atomic layer deposited on said sample is an elemental semiconductor.

7. The use of a vapor deposition apparatus for processing a vapor deposition method
(a) the method comprising:
placing a sample in a reaction chamber, evacuating the reaction chamber, introducing at least one gaseous material and applying at least one pulse of a pulse waveform light to the sample after introducing the at least one gaseous material, characterized in introducing the at least one gaseous material under such high partial pressure that the gaseous material can be entirely adsorbed on the substantially whole surface of the sample, after gaseous material has been entirely adsorbed on the substantially whole surface only one pulse of a pulse wavefrom light from a flash lamp is applied to the sample whereby one atomic layer is produced;
(b) the apparatus comprising:
a reaction chamber (1) having a window (8), a flash lamp (9) for applying a pulse waveform light to a sample (7) through the window (8), and comprising a stand (10) for placing the sample (7), further comprising a gas source (6) for supplying at least one gaseous material to said rear tion chamber (1), and comprising means for supplying the gaseous material under such high partial pressure that the gaseous material call be entirely, adsorbed on the substantially whole surface of the sample, and further comprising a control unit (18) for controlling the flash lamp (9) in order to emit only one pulse of a pulse waveform light to the surface of the sample after waiting a preselected lapse of time after the gaseous material is supplied to allow the gaseous material to be entirely adsorbed on the substantially whole surface of the sample for forming one atomic layer on the surface of the sample after the application of the one light pulse.

## Patentansprüche

1. Verfahren zur Dampfphasen-Abscheidung mit der Anordnung einer Probe in einer Reaktionskammer, Evakuierunq dieser Reaktionskammer, Einführung zumindest eines gasförmigen Stoffes in diese Reaktionskammer und Einwirkung zumindest eines Impulses eines wellenförmigen Lichtes auf die Probe nach Einführung des zumindest einen gasförmigen Stoffes in die Reaktionskammer, gekennzeichnet durch die Einführung des zumindest einen gasförmigen Stoffes unter einem solchen Partialdruck, daß dieser gasförmige Stoff von im wesentlichen der Oberfläche der Probe vollständig absorbiert werden kann, und gekennzeichnet dadurch, daß, nachdem der gasförmige Stoff vollständig von der gesamten Oberfläche der Probe absorbiert worden ist, lediglich ein Impuls des wellenförmig pulsierenden Lichtes von einer Blitzlichtlampe auf die Probe zur Einwirkung gebracht wird, wodurch eine Atomschicht erzeugt wird.

2. Verfahren zur Dampfphasen-Abscheidung wie in Anspruch 1 beansprucht, wobei gleichzeitig eine Mehrzahl gasförmiger Stoffe in die Reaktionskammer eingeführt werden, wodurch ein aus mehreren miteinander vermischten Kristallen bestehender Film erzeugt wird.

3. Verfahren zur Dampfphasen-Abscheidung wie in Anspruch 1 oder 2 beansprucht, wobei der Verfahrensschritt der Einwirkung nur eines Lichtimpulses nach der vollständigen Absorption des gasförmigen Stoffes durch die im wesentlichen gesamte Oberfläche der Probe mehrfach wiederholt wird, um eine Mehrzahl von Atomschichten zu erzeugen, wobei es dem gasförmigen Stoff möglich gemacht wird, zwischen jedem Lichtimpuls vollständig absorbiert zu werden.

4. Verfahren zur Dampfphasen-Abscheidung wie in Anspruch 1 oder 3 beansprucht, wobei die Verfahrensschritte der Einführung eines ersten gasförmigen Stoffes und der Einwirkung eines Lichtimpulses selektiv abwechselnd mit den Verfahrensschritten der Einführung eines anderen gasförmigen Stoffes und der Einwirkung eines Lichtimpulses zur selektiven Bildung verschiedener Atomschichten auf der Probe durchgeführt werden.

5. Verfahren zur Dampfphasen-Abscheidung wie in einem der Ansprüche 1 bis 4 beansprucht, wobei vor und nach der Einführung des zumindest einen gasförmigen Stoffes die Probe bei konstanter Temperatur erhitzt wird und zumindest ein anderer gasförmiger Stoff eingeführt wird, wobei der andere gasförmige Stoff zur Schichtbildung reagiert.

6. Verfahren zur Dampfphasen-Abscheidung wie im Anspruch 1 beansprucht, wobei die auf der Probe gebildete Schicht ein Elementarhalbleiter ist.

7. Verwendung einer Dampfphasen-Abscheidungs-Vorrichtung für die Durchführung eines Dampfphasen-Abscheidungs-Verfahrens
(a) wobei das Verfahren einschließt:
die Anordnung einer Probe in einer Reaktionskammer, Evakuierung dieser Reaktionskammer, Einführung zumindest eines gasförmigen Stoffes in diese Reaktionskammer und Einwirkung zumindest eines Impulses eines wellenförmig pulsierenden Lichtes auf die Probe nach Einführung des zumindest einen gasförmigen Stoffes in die Reaktionskammer in der Kennzeichnung dadurch, daß die Einführung des zumindest einen gasförmigen Stoffes unter einem Partialdruck erfolgt, der so hoch ist, daß der gasförmige Stoff von im wesentlichen der gesamten Oberfläche der Probe absorbiert werden kann, sodaß, nachdem der gasförmige Stoff von der im wesentlichen gesamten Oberfläche der Probe vollständig absorbiert worden ist und nur ein Impuls eines wellenförmig pulsierenden Lichtes durch eine Blitzlichtlampe zur Einwirkung auf die Probe gebracht worden ist, eine Atomschicht erzeugt wird;
(b) wobei die Vorrichtung einschließt:
eine Reaktionskammer (1) mit einem Fenster (8) , einer Blitzlichtlampe (9) für die Einwirkung eines wellenförmig pulsierenden Lichtes auf die Probe (7) durch das Fenster (8) hindurch, ferner eine Gasquelle (6) für die Einführung zumindest eines gasförmigen Stoffes in die Reaktionskammer (1), ferner ein Mittel für die Einführung des gasförmigen Stoffes unter einem so hohen Partialdruck, daß der gasförmige Stoff vollständig von der im wesentlichen gesamten Probenoberfläche absorbiert werden kann und schließlich auch noch eine Regeleinheit (18) zur Regelung der Blitzlichtlampe (9) derart, daß nur ein Impuls des wellenförmig pulsierenden Lichts zur Einwirkung auf die Probe gebracht wird, nachdem der gasförmige Stoff in die Kammer eingeführt worden ist, von der im wesentlichen gesamten Probenoberfläche absorbiert worden ist und danach eine ausgewählte Zeitspanne verstrichen ist, um eine Atomschicht auf der Probenoberfläche nach Einwirkung des einen Lichtimpulses zu bilden.

## Revendications

1. Un procédé de depot en couche de vapeur consistant à placer un échantillon dans une chambre de réaction, à évacuer la chambre de réaction, à introduire au moins une matière gazeuse et à appliquer à l'échantillon au moins une impulsion d'une lumière de forme d'onde impulsionnelle après introduction de ladite au moins une matière gazeuse, caractérisé en ce que l'introduction de ladite au moins une matière gazeuse est réalisée sous une pression partielle si élevée, que la matière gazeuse peut être intégralement adsorbée substantiellement sur la totalité de la surface de l'échantillon, après que la matière gazeuse ait été intégralement adsorbée substantiellement sur la totalité de la surface, seule une impulsion d'une lumière de forme d'onde impulsionnelle provenant d'une lampe éclair est appliquée à l'echantillon, une couche atomique étant de ce fait formée.

2. Un procédé de depot en couche de vapeur selon la revendication 1, dans lequel une pluralité de matières gazeuses sont introduites au même moment dans la chambre de réaction, un film composé de cristaux mélangés étant de ce fait forme.

3. Un procédé de dépôt en couche de vapeur selon la revendlnation 1 ou 2, dans lequel l'étape consistant à appliquer la seule impulsion lumineuse, après que la matière gazeuse ait été intégralement adsorbée substantiellement sur la totalité de la surface, est répétée un certain nombre de fois pour produire une pluralité de couches atomiques, dans lequel on laisse la matière gazeuse être intégralement adsorbée entre chaque impulsion.

4. Un procédé de dépôt en couche de vapeur selon la revendication 1 ou 3, dans lequel on alterne de façon sélective entre les étapes consistant à introduire une première matière gazeuse et à irradier avec la seule impulsion lumineuse et les étapes consistant à introduire une autre matière gazeuse et à irradier avec la seule impulsion lumineuse, pour produire, de façon sélective, différentes couches atomiques sur l'échantillon.

5. Un procédé de dépôt en couche de vapeur selon l'une des revendications 1 à 4, dans lequel, avant ou après l'introduction de ladite au moins une matière gazeuse, l'échantillon est chauffé à température constante et au moins une autre matière gazeuse est introduite, l'autre matière gazeuse réagissant chimiquement de ce fait pour former des couches.

6. Un procédé de dépôt en couche de vapeur selon la revendication 1, dans lequel la couche atomique déposée sur ledit échantillon est un semiconducteur élémentaire.

7. L'usage d'un dispositif pour le dopot d'une couche de vapeur pour un procédé de depot une couche de vapeur
(a) le procédé comprenant:
placer un échantillon dans une chambre de réaction, à évacuer la chambre de réaction, à introduire au moins une matière gazeuse et à appliquer à l'échantillon au moins une impulsion d'une lumière de forme d'onde impulsionnelle après introduction de ladite au moins une matière gazeuse, caractérisé en ce que l'introduction de ladite au moins une matière gazeuse est réalisée sous une pression partielle si élevée, que la matière gazeuse peut être intégralement adsorbée substantiellement sur la totalité de la surface de l'échantillon, après que la matière gazeuse ait été intégralement adsorbée substantiellement sur la totalité de la surface, seule une impulsion d'une lumière de forme d'onde impulsionnelle provenant d'une lampe éclair est appliquée à l'échantillon, une couche atomique étant de ce fait formée;
(b) le dispositif comprenant:
une chambre de réaction (1) avec une fenêtre (8), une lampe éclair (9) produisant une lumière de forme d'onde impulsionnelle agissant sur l'échantillon (7) à travers la fenêtre (8), une source de gaz (6) assurant l'introduction d'au moins une matière gazeuse dans la chambre de réaction (1), un organe pour l'introduction de la matière gazeuse sous une pression partielle si élevée que la matière gazeuse peut être intégralement adsorbée substantiellement sur la totalité de la surface de l'échantillon, et un régulateur (18) pour la lampe éclair (9) assurant que seule une impulsion de la lumière de forme d'onde impulsionnelle soit appliquée à l'échantillon après introduction de la matière gazeuse dans la chambre, adsorbée substantiellement sur la totalité de la surface de l'échantillon, et après écoulement d'un laps de temps déterminé pour former une couche atomique sur la surface de l'échantillon après l'action de l'unique impulsion de lumière.
